# FASCICULE DE BREVET EUROPEEN

(11) **EP 3 485 569 B1**
(45) Date de publication et mention de la délivrance du brevet: **17.02.2021**
(21) Numéro de dépôt: 17748543.0
(22) Date de dépôt: 13.07.2017
(51) Int. Cl.: H03K 17/10, H03K 17/691

(54) **GÉNÉRATEUR D'IMPULSIONS DE HAUTE TENSION**
HOCHSPANNUNGSIMPULSGENERATOR
HIGH-VOLTAGE PULSE GENERATOR

(30) Priorité: 13.07.2016 FR 1656773
(43) Date de publication de la demande: 22.05.2019
(73) Titulaire: Centre National de la Recherche Scientifique CNRS, 75016 Paris (FR); Université Paris-Saclay, 91190 Saint-Aubin (FR)
(72) Inventeur: FLEURY, Michel, 94110 Arcueil (FR); BAUVILLE, Gérard, 92170 Vanves (FR); PUECH, Vincent, 92100 Boulogne Billancourt (FR); LACOUR, Bernard, 91240 Saint Michel sur Orge (FR)
(74) Mandataire: Lavoix
(86) Numéro de dépôt international: PCT/FR2017/051927
(87) Numéro de publication internationale: WO 2018/011529

(56) Documents cités:
- US-A- 5 162 965
- US-A- 5 594 378
- US-A1- 2004 080 277
- US-A1- 2010 148 847

## Description

La présente invention est relative aux générateurs d'impulsions de haute tension et aux systèmes de production de jets de plasma utilisant de tels générateurs.

De tels générateurs d'impulsions de haute tension peuvent être utilisés dans des systèmes de production de jets de plasma par exemple pour le traitement de cancer par plasmathérapie, notamment par voie endoscopique ou coelioscopique.

Les systèmes de production de jets de plasma de la présente invention peuvent également trouver une application dans les domaines de la création de décharge électriques pour la génération de plasmas, par exemple pour des stérilisations, des décharges de surface, des décharges à barrière diélectrique, des jets de plasmas pour l'analyse de surface, des décharges pour le nettoyage voire encore le dépôt de couche mince notamment dans des endroits difficiles d'accès grâce à la propagation lointaine de plasma dans des capillaires souples.

Plus généralement, les générateurs d'impulsions de haute tension de la présente invention peuvent également trouver une application dans tous les domaines qui nécessitent une décharge électrique de haute tension sans qu'il y ait nécessairement création d'un plasma, par exemple pour la production et le guidage de faisceau d'électrons ou la production de rayons X.

Plus particulièrement, l'invention se rapporte à un générateur d'impulsions de haute tension comprenant :
- un générateur d'impulsions configuré pour la génération d'impulsions de commande,
- une partie haute comportant un nombre N de modules de partie haute,
chaque module de partie haute comprenant un transistor de partie haute à grille isolée ayant une grille, un drain et une source, ainsi qu'un dispositif de commande du transistor de partie haute,
le dispositif de commande du transistor de partie haute comprenant un transformateur d'impulsion connecté entre la grille et à la source du transistor et par l'intermédiaire duquel les impulsions de commande du générateur d'impulsions sont couplées au transistor,
les modules de partie haute étant reliés en série depuis un premier module jusqu'à un dernier module de telle sorte que la source d'un transistor d'un module de partie haute soit reliée au drain d'un transistor d'un module de partie haute adjacent.

Le document FR 2795572 décrit un tel générateur dans lequel une haute tension est appliquée entre la source et le drain d'un transistor unique ou sur une pluralité de transistors placés en série ou en parallèle

Le document US 5 594 378 A décrit un circuit modulateur rapide à haute tension permettant la commutation de hautes tensions et dont les temps d'activation et de désactivation (temps de montée et de descente) sont inférieurs à environ 10 nanosecondes.

Le document US 5 162 965 A concerne un interrupteur de courant à transistor à effet de champ (FET) à haute vitesse qui ouvre un circuit de cathode d'un tube à micro-ondes en cas d'arc électrique dans le tube.

Les transformateurs des dispositifs de commande de transistor d'un tel générateur permettent de réaliser un isolement galvanique entre le circuit de commande et le transistor.

De ce fait, il est possible de placer un grand nombre de transistors en série et d'obtenir un interrupteur supportant une très haute tension (dans le cas d'un arrangement en série) ou une intensité très importante (dans le cas d'un arrangement en parallèle), par exemple une tension de plusieurs kilovolts ou plusieurs dizaines de kilovolts pour un arrangement en série.

Par ailleurs, on peut réaliser des impulsions de avec des temps de montée particulièrement courts, de l'ordre de la nano-seconde.

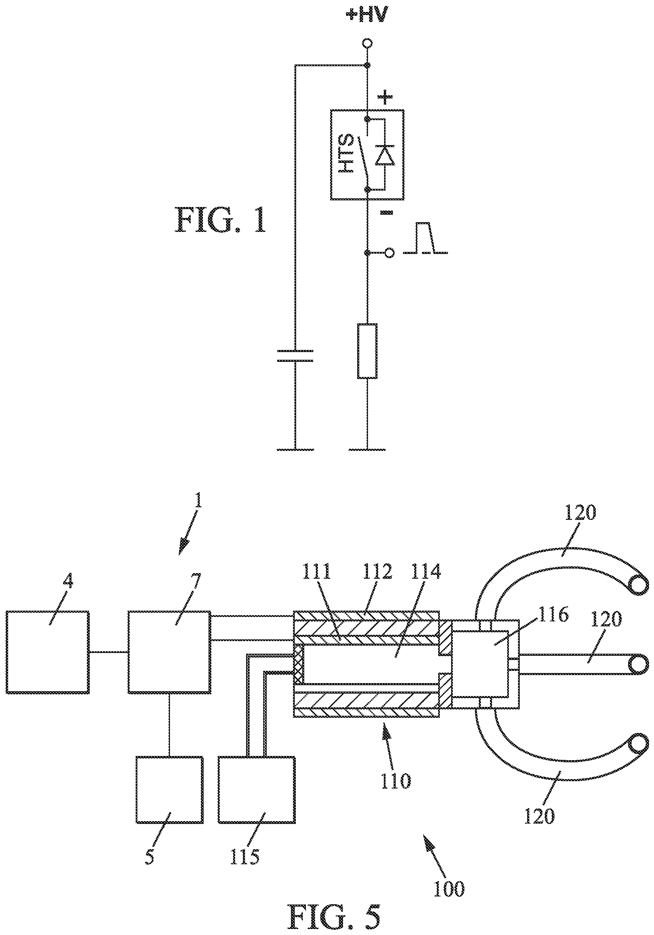

Toutefois, un tel montage ne permet pas d'obtenir des fronts de descente très courts, à moins de connecter à ce montage une résistance de charge de faible valeur ohmique comme illustré sur la figure 1.

La dissipation d'une telle résistance de charge est cependant rapidement prohibitive. Ainsi par exemple, si le générateur est utilisé pour produire un jet de plasma d'une puissance de l'ordre du milliwatt, la résistance de charge consommera quand à elle plus d'un kilowatt.

Par ailleurs, un tel montage permet uniquement d'obtenir des impulsions à signe constant, c'est-à-dire uniquement des impulsions de tension positive ou des impulsions de tension négative.

La présente invention a notamment pour but de pallier ces inconvénients.

A cet effet, selon l'invention, un générateur d'impulsions de haute tension du genre en question comprend en outre
- une partie basse comportant un nombre M de modules de partie basse,
   chaque module de partie basse comprenant un transistor à grille isolée ayant une grille, un drain et une source, ainsi qu'un dispositif de commande du transistor de partie basse,
   le dispositif de commande du transistor de partie basse comprenant des moyens de commande inversée du transistor de partie basse ainsi qu'un transformateur d'impulsion par l'intermédiaire duquel les impulsions de commande du générateur d'impulsions sont couplées aux moyens de commande inversée,
   les modules de partie basse étant reliés en série depuis un premier module jusqu'à un dernier module de telle sorte que la source d'un transistor d'un module de partie basse soit reliée au drain d'un premier transistor d'un module de partie basse adjacent,
- une source de haute tension continue connectée entre le transistor du premier module de partie haute et le transistor du dernier module de partie basse,
- une borne de sortie montée entre la partie haute et la partie basse, reliée au transistor du dernier module de partie haute et au transistor du premier module de partie basse.

Grâce à ces dispositions, il est possible de générer des impulsions avec des temps de descente particulièrement court avec un gain d'un facteur au moins 20 sur la puissance consommée. Les impulsions sont générées par une unique impulsion de commande qui vient commander simultanément les parties haute et basse du générateur. Le générateur est particulièrement simple et robuste de conception et est capable de supporter des tensions arbitrairement élevées en sélectionnant des nombres N et M de modules de parties haute et basse adapté pour supporter la haute tension choisie.

Dans des modes de réalisation préférés de l'invention, on peut éventuellement avoir recours en outre à l'une et/ou à l'autre des dispositions suivantes :
- les moyens de commande inversée du transistor de partie basse de chaque module de partie basse comportent :
   un deuxième transistor avec une source reliée à la source du transistor de partie basse et un drain reliée à la grille dudit transistor de partie basse,
   un dispositif d'alimentation du deuxième transistor alimentant le drain dudit deuxième transistor à partir du drain du transistor de partie basse,
   et le transformateur d'impulsion de partie basse est monté en parallèle avec le deuxième transistor en étant relié à la grille et à la source du deuxième transistor;
- ledit dispositif d'alimentation du deuxième transistor comporte un élément résistif d'alimentation du deuxième transistor monté entre le drain du deuxième transistor et le drain du transistor de partie basse ainsi que des moyens de régulation de tension entre le drain et la source du deuxième transistor;
- le nombre N de modules de partie haute est égal au nombre M de modules de partie basse;
- le générateur comprend en outre :
   un deuxième générateur d'impulsions de commande,
   une deuxième partie haute comportant un nombre N' de modules de deuxième partie haute,
   chaque module de deuxième partie haute comprenant un transistor de deuxième partie haute à grille isolée ayant une grille, un drain et une source, ainsi qu'un dispositif de commande du transistor de deuxième partie haute,
   le dispositif de commande du transistor de deuxième partie haute comprenant un transformateur d'impulsion de deuxième partie haute connecté entre la grille et à la source du transistor de deuxième partie haute, et par l'intermédiaire duquel les impulsions de commande du deuxième générateur d'impulsions sont couplées au transistor de deuxième partie haute,
   les modules de deuxième partie haute étant reliés en série depuis un premier module de deuxième partie haute jusqu'à un dernier module de deuxième partie haute de telle sorte que la source d'un transistor de deuxième partie haute d'un module de deuxième partie haute soit reliée au drain d'un transistor de deuxième partie haute d'un module de deuxième partie haute adjacent,
   une deuxième partie basse comportant un nombre M' de modules de deuxième partie basse,
   chaque module de deuxième partie basse comprenant un transistor de deuxième partie basse à grille isolée ayant une grille, un drain et une source, ainsi qu'un dispositif de commande du transistor de deuxième partie basse,
   le dispositif de commande du transistor de deuxième partie basse comprenant des moyens de commande inversée du transistor de deuxième partie basse ainsi qu'un transformateur d'impulsion de deuxième partie basse par l'intermédiaire duquel les impulsions de commande du deuxième générateur d'impulsions sont couplées aux moyens de commande inversée du transistor de deuxième partie basse,
   les modules de deuxième partie basse étant reliés en série depuis un premier module de deuxième partie basse jusqu'à un dernier module de deuxième partie basse de telle sorte que la source d'un transistor de deuxième partie basse d'un module de deuxième partie basse soit reliée au drain d'un transistor de deuxième partie basse d'un module de deuxième partie basse adjacent,
   une deuxième source de haute tension continue connectée entre le transistor de deuxième partie haute du premier module de deuxième partie haute et le transistor de deuxième partie basse du dernier module de deuxième partie basse,
   et la borne de sortie est reliée :
      au transistor de partie haute du dernier module de partie haute,
      au transistor de deuxième partie haute du dernier module de deuxième partie haute,
      au transistor de partie basse du premier module de partie basse, et
      au transistor de deuxième partie basse du premier module de deuxième partie basse;
         - la source de haute tension continue est une source de haute tension positive connectée entre le drain du transistor de partie haute du premier module de partie haute et la source du transistor de partie basse du dernier module de partie basse,
   la deuxième source de haute tension continue est une source de haute tension négative connectée entre la source du transistor de deuxième partie haute du premier module de deuxième partie haute et le drain du transistor de deuxième partie basse du dernier module de deuxième partie basse,
   la partie basse et la deuxième partie basse sont montée antiparallèlement de sorte à ce que
   le drain du transistor de partie basse du premier module de partie basse soit relié à la source du transistor de deuxième partie basse du premier module de deuxième partie basse et
   la source du transistor de partie basse du dernier module de partie basse soit relié au drain du transistor de deuxième partie basse du dernier module de deuxième partie basse, et
   chaque module de partie basse et chaque module de deuxième partie basse comporte en outre un dispositif bloquant monté en série avec le transistor à grille isolée dudit module, en particulier une diode;
      - le nombre N de modules de partie haute est égal au nombre N' de modules de deuxième partie haute;
      - un élément résistif et un élément capacitif sont montés en parallèle de chaque transistor de partie haute et de chaque transistor de partie basse, ainsi que le cas échéant de chaque transistor de deuxième partie haute et de chaque transistor de deuxième partie basse, de sorte à répartir la tension entre lesdits transistors;
      - un régulateur de tension est monté en parallèle de chaque transformateur d'impulsion de partie haute et de chaque transformateur d'impulsion de partie basse, ainsi que le cas échéant de chaque transformateur d'impulsion de deuxième partie haute et de chaque transformateur d'impulsion de deuxième partie basse.

L'invention a également pour objet un système de production de jets de plasma comprenant un générateur d'impulsions de haute tension tel que détaillé ci-avant ainsi qu'une source de plasma reliée à au moins un capillaire.

D'autres caractéristiques et avantages de l'invention apparaîtront au cours de la description suivante d'une de ses formes de réalisation, donnée à titre d'exemple non limitatif, en regard des dessins joints.

Sur les dessins :
- la figure 1 est un schéma d'organisation d'un circuit de l'art antérieur.
- la figure 2 illustre schématiquement un premier mode de réalisation d'un commutateur d'un générateur selon l'invention,
- les figures 3a et 3b illustrent schématiquement l'état du commutateur de la figure 2 respectivement en l'absence et en présence d'une impulsion de commande,
- la figure 4 illustre schématiquement un second mode de réalisation d'un commutateur d'un générateur selon l'invention,
- la figure 5 illustre schématiquement un système de production de jets de plasma selon un mode de réalisation de l'invention.

Sur les différentes figures, les mêmes références désignent des éléments identiques ou similaires.

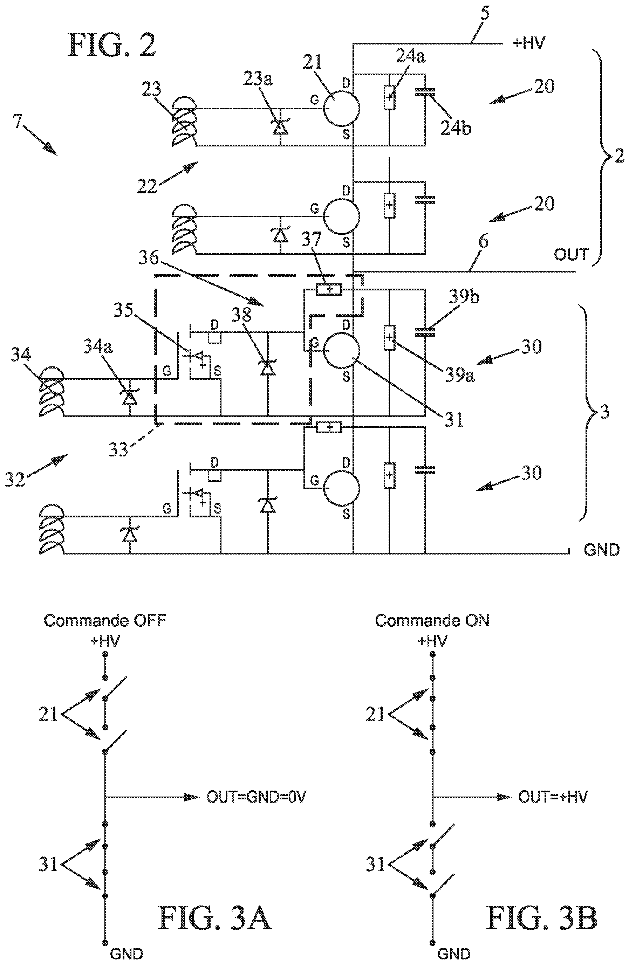

La figure 2 présente le schéma d'organisation d'un circuit réalisant un générateur d'impulsions de haute tension 1 selon un premier mode de réalisation de l'invention. Le générateur 1 comprend une partie haute 2 et une partie basse 3 montées en série.

Le générateur 1 comprend en outre un générateur d'impulsions de commande 4 adapté pour commander la partie haute 2 et la partie basse 3 comme cela est décrit plus bas.

Le générateur 1 comporte enfin une source de haute tension continue 5 et une borne de sortie 6 illustrées sur la figure 2.

En appliquant une haute tension HT entre l'extrémité libre de la partie haute 2 et l'extrémité libre la partie basse 3, on obtient, entre les deux extrémités de la partie basse 3 une tension contrôlée par les impulsions de commande du générateur d'impulsions de commande 4.

Le sous-système {2+3+4} est donc un commutateur 7 haute tension.

La partie haute 2 comporte un nombre N de modules de partie haute 20 reliés en série.

Chaque module de partie haute 20 comprend un transistor de partie haute 21 à grille isolée ayant une grille G, un drain D et une source S.

Les transistors de partie haute 21 sont des transistors de puissance, par exemple des transistors MOSFET ou des transistors IGBT.

Les transistors de partie haute 21 sont avantageusement aptes à supporter, individuellement, une tension supérieure à 1 kilovolt, par exemple une tension comprise entre 1.5 et 3 kilovolts.

A titre d'exemple purement indicatif et non limitatif, un transistor MOSFET à canal N à enrichissement commercialisé par la marque CREE™ sous la référence C2M1000170D peut être utilisé. Un tel transistor est apte à supporter une tension drain-source allant jusqu'à 1700 Volts.

Les modules de partie haute 20 sont reliés en série depuis un premier module 20a jusqu'à un dernier module 20n de telle sorte que la source S d'un transistor 21 d'un module de partie haute 20 soit reliée au drain D d'un transistor 21 d'un module de partie haute adjacent 20.

La partie haute est donc apte à supporter une haute tension égale à la tension maximale pouvant être supportée par chaque transistor de partie haute 21 multipliée par le nombre N de transistors.

Pour répartir et diviser équitablement la tension entre les transistors 21, chaque module de partie haute 20 peut comporter un élément résistif 24a et un élément capacitif 24b montés en parallèle du transistor 21 et reliant chacun la source et le drain dudit transistor 21. L'élément résistif 24a et l'élément capacitif 24b sont respectivement adaptés pour équilibrer les tensions aux bornes de chaque module de partie haute 20 respectivement en continu (statique) et en dynamique (impulsionnel).

Chaque module de partie haute 20 comprend par ailleurs un dispositif de commande 22 du transistor de partie haute 21.

Le dispositif de commande 22 du transistor de partie haute 21 comprend un transformateur 23 d'impulsion connecté entre la grille G et la source S du transistor 21 et par l'intermédiaire duquel les impulsions de commande du générateur d'impulsions 4 sont couplées au transistor 21.

Lorsqu'il reçoit une impulsion de commande du générateur d'impulsions 4, le dispositif de commande 22 applique sur la grille G du transistor 21 une tension de grille Vg adaptée pour rendre passant le transistor 21.

Le transformateur 23 a par exemple un enroulement primaire 23a connecté aux bornes du générateur d'impulsions 4 et un enroulement secondaire 23b connecté entre la grille G et la source S du transistor 21.

Dans un mode de réalisation particulier de l'invention, Le transformateur 23 peut être un élévateur de tension dont le rapport de transformation est supérieur ou égal à 1. Le transformateur 23 peut ainsi par exemple consister en un tore de ferrite dont le primaire comporte moins de spires que le secondaire. De cette manière, il est possible d'utiliser des impulsions de commande ayant une tension plus faible que la tension de grille Vg. On peut ainsi commander, avec une ligne unique de commande, un grand nombre de modules de parties basse et de partie haute tout en conservant une tension limitée des impulsions de commande du générateur d'impulsions 4.

Des moyens de régulation de tension 23a peuvent être montés en parallèle du transformateur 23 pour stabiliser la tension lorsqu'une impulsion est reçu du générateur d'impulsions 4, par exemple une diode Zener.

La partie basse 3 comporte quant à elle un nombre M de modules de partie basse 30.

Chaque module de partie basse 30 comprend un transistor à grille isolée 31 ayant également une grille G, un drain D et une source S.

Les transistors à grille isolée 31 de partie basse sont également des transistors de puissance et sont similaires aux transistors de partie haute 21 de sorte qu'ils ne seront pas décrits à nouveau.

Les modules de partie basse 30 sont également reliés en série depuis un premier module 30a jusqu'à un dernier module de 30m telle sorte que la source S d'un transistor 31 d'un module de partie basse 30 soit reliée au drain D d'un transistor 31 d'un module de partie basse adjacent 30.

La partie haute 2 et la partie basse 3 du générateur 1 sont reliées en série de sorte que le transistor 21 du dernier module 20n de partie haute 2 soit relié au transistor 31 du premier module 30a de partie basse 3.

La borne de sortie 6 est ainsi placée entre la partie haute 2 et la partie basse 3 en étant reliée audit transistor 21 du dernier module 20n de partie haute 2 et audit transistor 31 du premier module 30a de partie basse 3.

Ici également, pour répartir et diviser équitablement la tension entre les transistors 31, chaque module de partie basse 30 peut comporter un élément résistif 39a et un élément capacitif 39b montés en parallèle du transistor 31 et reliant chacun la source et le drain dudit transistor 31. L'élément résistif 39a et l'élément capacitif 39b sont respectivement adaptés pour équilibrer les tensions aux bornes de chaque module de partie basse 30 respectivement en continu (statique) et en dynamique (impulsionnel).

Chaque module de partie basse 30 comprend par ailleurs un dispositif de commande 32 du transistor de partie basse 31.

Le dispositif de commande 32 du transistor de partie basse 31 comporte des moyens de commande inversée 33 du transistor de partie basse 31 ainsi qu'un transformateur 34 d'impulsion par l'intermédiaire duquel les impulsions de commande du générateur d'impulsions 4 sont couplées aux moyens de commande inversée 33.

Les transformateurs 34 des modules 30 de partie basse sont similaires aux transformateurs 23 des modules 20 de partie haute et ne seront donc pas décrits à nouveau en détail.

Ici également, des moyens de régulation de tension 34a peuvent être montés en parallèle du transformateur 34 pour stabiliser la tension lorsqu'une impulsion est reçu du générateur d'impulsions 4, par exemple une diode Zener.

Les moyens de commande inversée 33 du transistor 31 de partie basse comportent par ailleurs un deuxième transistor 35 et un dispositif d'alimentation 36 du deuxième transistor 35.

Le deuxième transistor 35 comporte une source S, une grille G et un drain D. La source S du deuxième transistor 35 est reliée à la source S du transistor 31 à de partie basse et le drain D du deuxième transistor 35 est reliée à la grille G du transistor de partie basse 31.

Le deuxième transistor 35 est adapté pour réaliser une fonction d'inversion des impulsions de commande.

Pour cela, le deuxième transistor 35 est commandé par les impulsions de commande et alimenté par le dispositif d'alimentation 36.

Plus précisément, le transformateur 34 du module de partie basse 30 est monté en parallèle entre la grille G et la source S du deuxième transistor 35 et applique ainsi sur la grille G du deuxième transistor 35, une tension de grille Vg adaptée pour rendre passant le deuxième transistor 35 lorsque le transformateur 34 reçoit une impulsion de commande du générateur d'impulsions 4.

Par ailleurs le dispositif d'alimentation 36 alimente le deuxième transistor 35 à partir du drain D du transistor 31 de partie basse de la façon illustrée sur la figure 2.

Le dispositif d'alimentation 36 du deuxième transistor comporte ainsi par exemple un élément résistif 37 monté entre le drain D du deuxième transistor 35 et le drain D du transistor 31 de partie basse. Le dispositif d'alimentation 36 comporte en outre des moyens de régulation de tension 38 montés en parallèle entre le drain D et la source S du deuxième transistor 35, par exemple une diode Zener.

De cette manière, le circuit 33 formé par le deuxième transistor 35 et le dispositif d'alimentation 36 commande le transistor 31 de partie basse de manière inversée à l'impulsion de commande reçu du générateur d'impulsions de commande 4.

En se référant aux figures 3A et 3B, on voit ainsi que, en l'absence d'impulsion de commande du générateur d'impulsions de commande 4, les transistors de partie haute 21 sont ouverts et les transistors de partie basse 31 sont commandés par les dispositifs de commande 32 respectifs pour être dans l'état fermé. Aucun courant ne circule vers la charge et la tension de sortie est donc nulle (figure 3A) .

Lorsque le générateur d'impulsions de commande 4 émet une impulsion de commande, les transistors de partie haute 21 sont commandé par les dispositifs de commande 22 pour passer à l'état fermé tandis que les transistors de partie basse 31 basculent dans l'état ouvert. Le courant circule alors dans la charge et la tension de sortie est égale à, ou sensiblement proche de, la tension appliquée par la source haute tension 5 (figure 3B).

Dans le montage à une seule source haute tension 5 illustré sur les figures 2, 3A et 3B, la partie haute 2 et la partie basse 3 supportent alternativement la tension appliquée par la source haute tension 5, selon la présence ou l'absence d'une impulsion de commande.

Le nombre N de modules 20 de partie haute est donc avantageusement égal au nombre M de modules 30 de partie basse.

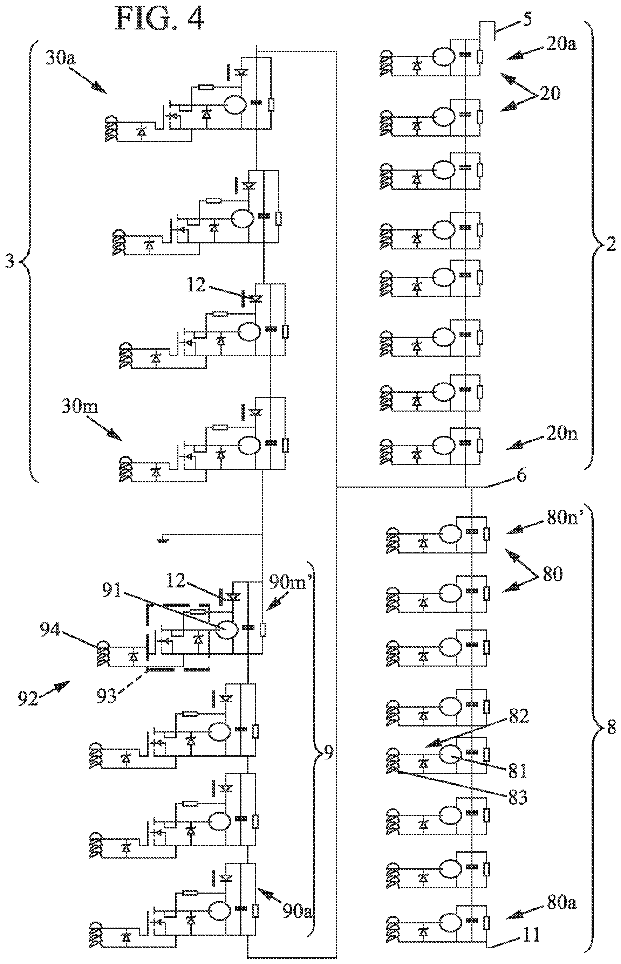

On se réfère à présent à la figure 4 sur laquelle est illustré un deuxième mode de réalisation de l'invention.

Comme illustré sur la figure 4, dans ce mode de réalisation, le générateur 1 comporte additionnement aux éléments décrits ci-dessus, une deuxième partie haute 8, une deuxième partie basse 9, un deuxième générateur d'impulsions de commande 10 et une deuxième source de haute tension continue 11.

La deuxième partie haute 8 comportant un nombre N' de modules de deuxième partie haute 80.

Les modules de deuxième partie haute 80 peuvent en particulier être identiques aux modules de partie haute 20 et ne seront pas décrit à nouveau en détail, référence étant faite est explication fournies plus haut concernant les modules de partie haute 20.

Chaque module 80 de deuxième partie haute comprend un transistor 81 ainsi qu'un dispositif de commande 82 du transistor de deuxième partie haute 81, comprenant un transformateur d'impulsion 83 connecté entre la grille G et à la source S du transistor 81 et par l'intermédiaire duquel les impulsions de commande du deuxième générateur d'impulsions 10 sont couplées au transistor de deuxième partie haute 81.

Les modules de deuxième partie haute 80 sont également reliés en série depuis un premier module 80a jusqu'à un dernier module 80n' de telle sorte que la source S d'un transistor 81 d'un module de deuxième partie haute soit reliée au drain D d'un transistor d'un module de deuxième partie haute 81 adjacent.

La deuxième partie basse 9 comporte un nombre M' de modules de deuxième partie basse 90.

Ici également, les modules de deuxième partie basse 90 peuvent en particulier être identiques aux modules de partie basse 30 et ne seront pas décrit à nouveau en détail, référence étant faite aux explications fournies plus haut concernant les modules de partie basse 30.

Chaque module de deuxième partie basse 90 comprend un transistor à grille isolée 91 ainsi qu'un dispositif de commande 92 comprenant des moyens de commande inversée 93 dudit transistor 91 ainsi qu'un transformateur d'impulsion 94 par l'intermédiaire duquel les impulsions de commande du deuxième générateur d'impulsions 10 sont couplées aux moyens de commande inversée 93.

Les modules de deuxième partie basse 90 sont reliés en série depuis un premier module 90a jusqu'à un dernier module 90m' de telle sorte que la source S d'un transistor 91 d'un module de deuxième partie soit reliée au drain D d'un transistor 91 d'un module de deuxième partie basse adjacent.

La deuxième source de haute tension continue 11 est connectée entre le transistor 81 du premier module 80a de deuxième partie haute 8 et le transistor 91 du dernier module 90m' de deuxième partie basse 9.

Comme illustré sur la figure 4, dans ce mode de réalisation, la borne de sortie 6 est reliée :
- au transistor 21 du dernier module 20n de partie haute 2,
- au transistor 81 du dernier module 80n' de deuxième partie haute 8,
- au transistor 31 du premier module 30a de partie basse 3, et
- au transistor 91 du premier module 90a de deuxième partie basse 9.

Ce mode de réalisation permet de générer, séquentiellement et de manière contrôlée, des impulsions de tensions différentes en utilisant sélectivement le générateur d'impulsions de commande 4 ou le deuxième générateur d'impulsions de commande 10.

En particulier ce deuxième mode de réalisation permet de générer des impulsions de haute tension positives et/ou négatives.

A cette fin, la source de haute tension continue 5 peut être une source de haute tension positive et la deuxième source de haute tension continue 11 peut être une source de haute tension négative.

La source de haute tension continue 5 est alors par exemple connectée entre le drain D du transistor 21 du premier module 20a de partie haute 2 et la source S du transistor 31 du dernier module 30m de partie basse 3.

La deuxième source de haute tension continue 11 est quant à elle connectée entre la source S du transistor 81 du premier module 80a de deuxième partie haute 8 et le drain D du transistor 91 du dernier module 90m' de deuxième partie basse 9.

Comme illustré sur la figure 4, la partie basse 3 et la deuxième partie basse 9 sont alors avantageusement montées antiparallèlement. La source S du transistor 30 du dernier module 30m de partie basse 3 et le drain D du transistor 91 du dernier module 90m' de deuxième partie basse 9 sont reliés ensemble d'une part, et le drain D du transistor 31 du premier module 30a de partie basse 3 et la source S du transistor 91 du premier module 90a de deuxième partie basse 9 sont reliés ensemble d'autre part.

Dans cette variante, la borne de sortie 6 est alors plus précisément reliée :
- à la source S du transistor 21 du dernier module 20n de partie haute 2,
- au drain D du transistor 31 du premier module 30a de partie basse 3,
- au drain D du transistor 81 du dernier module 80n' de deuxième partie haute 8, et
- à la source S du transistor 91 du premier module 90a de deuxième partie basse 9.

Enfin, chaque module de partie basse 30 et chaque module deuxième partie basse 90 comporte par ailleurs un dispositif bloquant 12 monté en série avec le transistor 31, 91 à grille isolée dudit module 30, 90.

Le dispositif bloquant 12 est par exemple une diode montée en amont dudit transistor 31, 91.

La diode 12 est choisie de manière à pouvoir supporter la tension appliquée à chaque module de partie basse et de deuxième partie basse.

Ledit dispositif bloquant 12 peut en particulier être monté en amont des moyens de commande inversée 33, 93 dudit module 30, 90 comme illustré sur la figure 4.

Dans ce mode de réalisation, le nombre N de modules de partie haute et le nombre N' de modules de deuxième partie haute sont avantageusement égaux et tels que la partie haute et la deuxième partie basse supportent chacune la somme totale des tensions délivrées par la source de tension 5 et la source de tension 11.

Le nombre de module M de la partie basse et du nombre M' de la deuxième partie basse sont dimensionnés de telle sorte que la partie basse et la deuxième partie basse supportent chacune la plus grande des tensions en valeur absolue parmi la tension délivrée par la source de tension 5 et la tension délivrée par la source de tension 11.

Ainsi dans l'exemple non-limitatif de la figure 4, la tension délivrée par la source de tension 5 et la tension délivrée par la source de tension 11 sont égales en valeur absolue et de signe opposé. Dans ce cas la partie haute et la deuxième partie haute peuvent toute deux comporter un nombre pair 2P de modules tandis que la partie basse et la deuxième partie basse peuvent toute deux comporter un nombre P de modules égal à la moitié du nombre de modules des partie haute et deuxième partie haute. Ceci provient du fait que la partie basse et la deuxième partie basse sont arrangées anti-parallèlement l'une à l'autre.

Le nombre N de modules de la partie haute est de préférence supérieur à deux modules.

De même, le nombre N' de modules de la deuxième partie haute est de préférence supérieur à deux modules.

Le générateur selon l'invention peut par exemple comporter des nombres N et N' de modules de partie haute et deuxième partie haute supérieures à 6 modules, en particulier supérieures à 10 modules, par exemple de plusieurs dizaines de modules.

Les nombres M et M' de modules de la partie basse et de la deuxième partie basse sont adaptés comme indiqué ci-avant.

L'invention a également pour objet un système 100 de production de jets de plasma comprenant un générateur d'impulsions de haute tension 1 tel que décrit ci-avant. Un tel system est illustré sur la figure 5 et permet de produire un ou plusieurs jets de plasma se propageant dans des capillaires souples. Les jets de plasma peuvent par exemple permettre de traiter des tissus cibles d'un patient, atteints par voie endoscopique ou coelioscopique. A cette fin, les jets de plasma se propagent sur une longueur important (plusieurs dizaines de centimètres) avant de déboucher à l'air libre à proximité desdits tissus cibles.

Le système 100 comporte un générateur d'impulsions de haute tension 1 tel que décrit ci-avant, une source de plasma 110 pouvant supporter des tensions élevées et un ou plusieurs capillaires 120 conduisant les divers jets de plasma sur les cibles à traiter, en particulier des capillaires souples et biocompatibles.

Le générateur 1 haute tension est par exemple adapté pour générer des impulsions avec une tension supérieure à 40 kV.

Les caractéristiques temporelles des impulsions de tension sont par exemple les suivantes :
- temps de montée et de descente de l'ordre de 150 ns,
- environ 150 V/ns pour la montée et 200 V/ns pour la descente,
- largeur des impulsions variant de moins de 200 ns à plus de 20 µs et
- fréquence de répétition atteignant 20 kHz.

Dans certaines réalisations, les temps de montée et de descente peuvent être inférieurs à 50ns et les fréquences de répétition peuvent atteindre plusieurs dizaines de kilohertz.

Les caractéristiques des impulsions de tension obtenues sont notamment fonction du nombre de modules ainsi que des composants utilisés et peuvent être ajustée en fonction de l'application visée sans départir de la présente invention.

De telles impulsions de tension permettent d'obtenir des jets de plasma plus de 80 cm de long.

Ces valeurs numériques sur les impulsions et les jets de plasma sont fournies à titre d'exemples purement indicatifs et non-limitatifs.

La source de plasma 110 est adaptée pour soutenir de telles impulsions de tension.

La source de plasma 110 est par exemple constituée d'une structure 114 comportant de deux électrodes cylindriques 111, 112, une électrode interne 111 et une électrode externe 112, séparées par un diélectrique 113 dont l'épaisseur est ajustée en fonction de la tension à supporter.

L'électrode interne 111 est par exemple portée à la haute tension et l'électrode externe 112 est par exemple reliée à la masse.

Un flux de gaz rares (hélium néon, argon) purs ou contenant un pourcentage donné de gaz moléculaire (azote, oxygène, air, HMDSO ou autre) est admis dans la structure 114 au travers de l'électrode 111 haute tension à partir d'une source 115 de gaz. En sortie de diélectrique 113 une cavité 116 percée d'un ou de plusieurs orifices permet le branchement des capillaires souples 120.

Les capillaires souples 120 peuvent par exemple avoir des diamètres internes et/ou externes compris entre 50 µm et 5 mm et une longueur allant jusqu'à 1m. Ils permettent ainsi d'obtenir un traitement très localisé.

## Revendications

1. Générateur (1) d'impulsions de haute tension comprenant :
- un générateur d'impulsions (4) configuré pour la génération d'impulsions de commande
- une partie haute (2) comportant un nombre N de modules de partie haute (20),
chaque module de partie haute (20) comprenant un transistor de partie haute (21) à grille isolée ayant une grille, un drain et une source, ainsi qu'un dispositif de commande (22) du transistor de partie haute,
le dispositif de commande (22) du transistor de partie haute comprenant un transformateur d'impulsion (23) de partie haute connecté entre la grille et la source du transistor de partie haute (21) et par l'intermédiaire duquel les impulsions de commande du générateur d'impulsions sont couplées au transistor de partie haute (21),
les modules de partie haute (20) étant reliés en série depuis un premier module jusqu'à un dernier module de telle sorte que la source d'un transistor de partie haute (21) d'un module de partie haute (20) soit reliée au drain d'un transistor de partie haute (21) d'un module de partie haute (20) adjacent,
le générateur d'impulsions de haute tension comprenant en outre
- une partie basse (3) comportant un nombre M de modules de partie basse (30),
chaque module de partie basse (30) comprenant un transistor de partie basse (31) à grille isolée ayant une grille, un drain et une source, ainsi qu'un dispositif de commande (32) du transistor de partie basse,
le dispositif de commande (32) du transistor de partie basse comprenant des moyens de commande inversée (33) du transistor de partie basse ainsi qu'un transformateur d'impulsion (34) de partie basse par l'intermédiaire duquel les impulsions de commande du générateur d'impulsions sont couplées aux moyens de commande inversée (33) du transistor de partie basse,
les modules de partie basse (30) étant reliés en série depuis un premier module de partie basse (30a) jusqu'à un dernier module de partie basse (30m) de telle sorte que la source d'un transistor de partie basse (31) d'un module de partie basse (30) soit reliée au drain d'un transistor de partie basse (31) d'un module de partie basse (30) adjacent,
- une source de haute tension continue (5) connectée entre le transistor de partie haute (21) du premier module de partie haute (20a) et le transistor de partie basse (31) du dernier module de partie basse (30m),
- une borne de sortie (6) montée entre la partie haute (2) et la partie basse (3), reliée au transistor de partie haute (21) du dernier module de partie haute (20n) et au transistor de partie basse (31) du premier module de partie basse (30a),
les moyens de commande inversée (33) du transistor de partie basse de chaque module de partie basse (30) comportant :
- un deuxième transistor (35) avec une source reliée à la source du transistor de partie basse (31) et un drain reliée à la grille dudit transistor de partie basse (31),
- un dispositif d'alimentation (36) du deuxième transistor alimentant le drain dudit deuxième transistor (35) à partir du drain du transistor de partie basse (31),
et dans lequel le transformateur d'impulsion (34) de partie basse est monté en parallèle avec le deuxième transistor (35) en étant relié à la grille et à la source du deuxième transistor (35).

2. Générateur selon la revendication 1, dans lequel ledit dispositif d'alimentation (36) du deuxième transistor comporte un élément résistif (37) d'alimentation du deuxième transistor monté entre le drain du deuxième transistor (35) et le drain du transistor de partie basse (31) ainsi que des moyens de régulation de tension (23a) entre le drain et la source du deuxième transistor (35).

3. Générateur selon l'une des revendications 1 et 2, dans lequel le nombre N de modules de partie haute (20) est égal au nombre M de modules de partie basse (30).

4. Générateur selon l'une des revendications 1 à 3, comportant en outre :
- un deuxième générateur d'impulsions de commande (10),
- une deuxième partie haute (8) comportant un nombre N' de modules de deuxième partie haute (80),
chaque module de deuxième partie haute (80) comprenant un transistor de deuxième partie haute (81) à grille isolée ayant une grille, un drain et une source, ainsi qu'un dispositif de commande (82) du transistor de deuxième partie haute,
le dispositif de commande (82) du transistor de deuxième partie haute comprenant un transformateur d'impulsion (83) de deuxième partie haute connecté entre la grille et à la source du transistor de deuxième partie haute (81), et par l'intermédiaire duquel les impulsions de commande du deuxième générateur d'impulsions sont couplées au transistor de deuxième partie haute (81),
les modules de deuxième partie haute (80) étant reliés en série depuis un premier module de deuxième partie haute (80a) jusqu'à un dernier module de deuxième partie haute (80n') de telle sorte que la source d'un transistor de deuxième partie haute (81) d'un module de deuxième partie haute (80) soit reliée au drain d'un transistor de deuxième partie haute (81) d'un module de deuxième partie haute (80) adjacent,
- une deuxième partie basse (9) comportant un nombre M' de modules de deuxième partie basse (90),
chaque module de deuxième partie basse (90) comprenant un transistor de deuxième partie basse (91) à grille isolée ayant une grille, un drain et une source, ainsi qu'un dispositif de commande (92) du transistor de deuxième partie basse,
le dispositif de commande (92) du transistor de deuxième partie basse comprenant des moyens de commande inversée (93) du transistor de deuxième partie basse ainsi qu'un transformateur d'impulsion (94) de deuxième partie basse par l'intermédiaire duquel les impulsions de commande du deuxième générateur d'impulsions sont couplées aux moyens de commande inversée (93) du transistor de deuxième partie basse,
les modules de deuxième partie basse (90) étant reliés en série depuis un premier module de deuxième partie basse (91a) jusqu'à un dernier module de deuxième partie basse (91m') de telle sorte que la source d'un transistor de deuxième partie basse (91) d'un module de deuxième partie basse (90) soit reliée au drain d'un transistor de deuxième partie basse (91) d'un module de deuxième partie basse (90) adjacent,
- une deuxième source de haute tension continue (11) connectée entre le transistor de deuxième partie haute (81) du premier module de deuxième partie haute (80a) et le transistor de deuxième partie basse (91) du dernier module de deuxième partie basse (91m'),
et dans lequel la borne de sortie (6) est reliée :
au transistor de partie haute (21) du dernier module de partie haute (20n),
au transistor de deuxième partie haute (81) du dernier module de deuxième partie haute (80n'),
au transistor de partie basse (31) du premier module de partie basse (20a), et
au transistor de deuxième partie basse (91) du premier module de deuxième partie basse (91a).

5. Générateur selon la revendication 4, dans lequel la source de haute tension continue (5) est une source de haute tension positive connectée entre le drain du transistor de partie haute (21) du premier module de partie haute (20a) et la source du transistor de partie basse (31) du dernier module de partie basse (30m),
dans lequel la deuxième source de haute tension continue (11) est une source de haute tension négative connectée entre la source du transistor de deuxième partie haute (81) du premier module de deuxième partie haute (80a) et le drain du transistor de deuxième partie basse (91) du dernier module de deuxième partie basse (91m'),
dans lequel la partie basse (3) et la deuxième partie basse (9) sont montée antiparallèlement de sorte à ce que
- le drain du transistor de partie basse (31) du premier module de partie basse (30a) soit relié à la source du transistor de deuxième partie basse (91) du premier module de deuxième partie basse (90a) et
- la source du transistor de partie basse (31) du dernier module de partie basse (30m) soit relié au drain du transistor de deuxième partie basse (91) du dernier module de deuxième partie basse (90m'), et
dans lequel chaque module de partie basse (30) et chaque module de deuxième partie basse (90) comporte en outre un dispositif bloquant (12) monté en série avec le transistor à grille isolée dudit module, en particulier une diode.

6. Générateur selon l'une des revendications 4 et 5, dans lequel le nombre N de modules de partie haute (20) est égal au nombre N' de modules de deuxième partie haute (80) .

7. Générateur selon l'une des revendications 1 à 6, dans lequel un élément résistif et un élément capacitif sont montés en parallèle de chaque transistor de partie haute (21) et de chaque transistor de partie basse (31), ainsi que le cas échéant de chaque transistor de deuxième partie haute (81) et de chaque transistor de deuxième partie basse (91), de sorte à répartir la tension entre lesdits transistors.

8. Générateur selon l'une des revendications 1 à 7, dans lequel un régulateur de tension est monté en parallèle de chaque transformateur d'impulsion (23) de partie haute et de chaque transformateur d'impulsion (34) de partie basse, ainsi que le cas échéant de chaque transformateur d'impulsion (83) de deuxième partie haute et de chaque transformateur d'impulsion (94) de deuxième partie basse.

9. Système (100) de production de jets de plasma comprenant un générateur (1) d'impulsions de haute tension selon l'une des revendications 1 à 8 ainsi qu'une source de plasma (110) reliée à au moins un capillaire (120).

## Patentansprüche

1. Generator (1) für Hochspannungspulse, aufweisend:
- einen Pulsgenerator (4), welcher eingerichtet ist für das Erzeugen von Steuerpulsen,
- einen Oberteil (2), welcher eine Anzahl N an Oberteil-Modulen (20) aufweist,
wobei jedes Oberteil-Modul (20) aufweist einen Oberteil-Transistor (21) mit isoliertem Gate, welcher ein Gate, einen Drain und eine Source hat, sowie eine Vorrichtung zum Steuern (22) des Oberteil-Transistors,
wobei die Vorrichtung zum Steuern (22) des Oberteil-Transistors einen Oberteil-Pulstransformator (23) aufweist, welcher zwischen das Gate und die Source des Oberteil-Transistors (21) geschaltet ist und mittels welchem die Pulse zum Steuern des Pulsgenerators an den Oberteil-Transistor (21) gekoppelt werden,
wobei die Oberteil-Module (20) von einem ersten Modul bis zu einem letzten Modul in Reihe geschaltet sind, sodass die Source eines Oberteil-Transistors (21) eines Oberteil-Moduls (20) mit dem Drain eines Oberteil-Transistors (21) eines angrenzenden Oberteil-Moduls (20) verbunden ist,
wobei der Hochspannungspulsgenerator ferner aufweist:
- einen Unterteil (3), welcher eine Anzahl M an Unterteil-Modulen (30) aufweist,
wobei jedes Unterteil-Modul (30) aufweist einen Unterteil-Transistor (31) mit isoliertem Gate, welcher ein Gate, einen Drain und eine Source hat, sowie eine Vorrichtung zum Steuern (32) des Unterteil-Transistors,
wobei die Vorrichtung zum Steuern (32) des Unterteil-Transistors aufweist Mittel zum invertierten Steuern (33) des Unterteil-Transistors sowie einen Unterteil-Pulstransformator (34) mittels welchem die Pulse zum Steuern des Pulsgenerators an die Mittel zum invertierten Steuern (33) des Unterteil-Transistors gekoppelt werden,
wobei die Unterteil-Module (30) von einem ersten Unterteil-Modul (30a) bis zu einem letzten Unterteil-Modul (30m) in Reihe geschaltet sind, sodass die Source eines Unterteil-Transistors (31) eines Unterteil-Moduls (30) mit dem Drain eines Unterteil-Transistors (31) eines angrenzenden Unterteil-Moduls (30) verbunden ist,
- eine Gleichstrom-Hochspannungsquelle (5), welche zwischen den Oberteil-Transistor (21) des ersten Oberteil-Moduls (20a) und den Unterteil-Transistor (31) des letzten Unterteil-Moduls (30m) geschaltet ist,
- einen zwischen dem Oberteil (2) und dem Unterteil (3) montierten Ausgangsanschluss (6), welcher mit dem Oberteil-Transistor (21) des letzten Oberteil-Moduls (20n) und mit dem Unterteil-Transistor (31) des ersten Unterteil-Moduls (30a) verbunden ist,
wobei die Mittel zum invertierten Steuern (33) des Unterteil-Transistors jedes Unterteil-Moduls (30) aufweisen:
- einen zweiten Transistor (35) mit einer Source, welche mit der Source des Unterteil-Transistors (31) verbunden ist, und einem Drain, welcher mit dem Gate des besagten Unterteil-Transistors (31) verbunden ist,
- eine Vorrichtung zur Versorgung (36) des zweiten Transistors, welche den Drain des besagten zweiten Transistors (35) ausgehend vom Drain des Unterteil-Transistors (31) versorgt,
und wobei der Unterteil-Pulstransformator (34) parallel zum zweiten Transistor (35) montiert ist, während er mit dem Gate und mit der Source des zweiten Transistors (35) verbunden ist.

2. Generator gemäß Anspruch 1, wobei die besagte Vorrichtung zur Versorgung (36) des zweiten Transistors aufweist ein Widerstandselement (37) zur Versorgung des zweiten Transistors, welches zwischen dem Drain des zweiten Transistors (35) und dem Drain des Unterteil-Transistors (31) montiert ist, sowie Mittel zum Regeln der Spannung (23a) zwischen dem Drain und der Source des zweiten Transistors (35).

3. Generator gemäß einem der Ansprüche 1 und 2, wobei die Anzahl N an Oberteil-Modulen (20) gleich ist zur Anzahl M an Unterteil-Modulen (30).

4. Generator gemäß einem der Ansprüche 1 bis 3, welcher ferner aufweist:
- einen zweiten Generator für Pulse zum Steuern (10),
- einen zweiten Oberteil (8), welcher eine Anzahl N' an Zweiter-Oberteil-Modulen (80) aufweist,
wobei jedes Zweiter-Oberteil-Modul (80) aufweist einen Zweiter-Oberteil-Transistor (81) mit isoliertem Gate, welcher ein Gate, einen Drain und eine Source hat, sowie eine Vorrichtung zum Steuern (82) des Zweiter-Oberteil-Transistors,
wobei die Vorrichtung zum Steuern (82) des Zweiter-Oberteil-Transistors einen Zweiter-Oberteil-Pulstransformator (83) aufweist, welcher zwischen das Gate und die Source des Zweiter-Oberteil-Transistors (81) geschaltet ist und mittels welchem die Pulse zum Steuern des zweiten Pulsgenerators an den Zweiter-Oberteil-Transistor (81) gekoppelt werden,
wobei die Zweiter-Oberteil-Module (80) von einem ersten Zweiter-Oberteil-Modul (80a) bis zu einem letzten Zweiter-Oberteil-Modul (80n') in Reihe geschaltet sind, sodass die Source eines Zweiter-Oberteil-Transistors (81) eines Zweiter-Oberteil-Moduls (80) mit dem Drain eines Zweiter-Oberteil-Transistors (81) eines angrenzenden Zweiter-Oberteil-Moduls (80) verbunden ist,
- einen zweiten Unterteil (9), welcher eine Anzahl M' an Zweiter-Unterteil-Modulen (90) aufweist,
wobei jedes Zweiter-Unterteil-Modul (90) aufweist einen Zweiter-Unterteil-Transistor (91) mit isoliertem Gate, welcher ein Gate, einen Drain und eine Source hat, sowie eine Vorrichtung zum Steuern (92) des Zweiter-Unterteil-Transistors,
wobei die Vorrichtung zum Steuern (92) des Zweiter-Unterteil-Transistors aufweist Mittel zum invertierten Steuern (93) des Zweiter-Unterteil-Transistors sowie einen Zweiter-Unterteil-Pulstransformator (94) mittels welchem die Pulse zum Steuern des zweiten Pulsgenerators an die Mittel zum invertierten Steuern (93) des Zweiter-Unterteil-Transistors gekoppelt werden,
wobei die Zweiter-Unterteil-Module (90) von einem ersten Zweiter-Unterteil-Modul (91a) bis zu einem letzten Zweiter-Unterteil-Modul (91m') in Reihe geschaltet sind, sodass die Source eines Zweiter-Unterteil-Transistors (91) eines Zweiter-Unterteil-Moduls (90) mit dem Drain eines Zweiter-Unterteil-Transistors (91) eines angrenzenden Zweiter-Unterteil-Moduls (90) verbunden ist,
- eine zweite Gleichstrom-Hochspannungsquelle (11), welche zwischen den Zweiter-Oberteil-Transistor (81) des ersten Zweiter-Oberteil-Moduls (80a) und den Zweiter-Unterteil-Transistor (91) des letzten Zweiter-Unterteil-Moduls (91m') geschaltet ist,
und wobei der Ausgangsanschluss (6) verbunden ist:
mit dem Oberteil-Transistor (21) des letzten Oberteil-Moduls (20n),
mit dem Zweiter-Oberteil-Transistor (81) des letzten Zweiter-Oberteil-Moduls (80n'),
mit dem Unterteil-Transistor (31) des ersten Unterteil-Moduls (20a) und
mit dem Zweiter-Unterteil-Transistor (91) des ersten Zweiter-Unterteil-Moduls (91a).

5. Generator gemäß Anspruch 4, wobei die Gleichstrom-Hochspannungsquelle (5) eine Positive-Hochspannung-Quelle ist, welche zwischen den Drain des Oberteil-Transistors (21) des ersten Oberteil-Moduls (20a) und die Source des Unterteil-Transistors (31) des letzten Unterteil-Moduls (30m) geschaltet ist,
wobei die zweite Gleichstrom-Hochspannungsquelle (11) eine Negative-Hochspannung-Quelle ist, welche zwischen die Source des Zweiter-Oberteil-Transistors (81) des ersten Zweiter-Oberteil-Moduls (80a) und den Drain des Zweiter-Unterteil-Transistors (91) des letzten Zweiter-Unterteil-Moduls (91m') geschaltet ist,
wobei der Unterteil (3) und der zweite Unterteil (9) antiparallel montiert sind, sodass
- der Drain des Unterteil-Transistors (31) des ersten Unterteil-Moduls (30a) mit der Source des Zweiter-Unterteil-Transistors (91) des ersten Zweiter-Unterteil-Moduls (90a) verbunden ist und
- die Source des Unterteil-Transistors (31) des letzten Unterteil-Moduls (30m) mit dem Drain des Zweiter-Unterteil-Transistors (91) des letzten Zweiter-Unterteil-Moduls (90m') verbunden ist, und
wobei jedes Unterteil-Modul (30) und jedes Zweiter-Unterteil-Modul (90) ferner eine Blockiervorrichtung (12) aufweist, welche in Reihe mit dem Transistor mit isoliertem Gate des besagten Moduls installiert ist, insbesondere eine Diode.

6. Generator gemäß einem der Ansprüche 4 und 5, wobei die Anzahl N an Oberteil-Modulen (20) gleich ist zur Anzahl N' an Zweiter-Oberteil-Modulen (80).

7. Generator gemäß einem der Ansprüche 1 bis 6, wobei ein Widerstandselement und ein Kapazitätselement parallel zu jedem Oberteil-Transistor (21) und zu jedem Unterteil-Transistor (31) montiert sind, sowie gegebenenfalls zu jedem Zweiter-Oberteil-Transistor (81) und zu jedem Zweiter-Unterteil-Transistor (91), um die Spannung zwischen den besagten Transistoren aufzuteilen.

8. Generator gemäß einem der Ansprüche 1 bis 7, wobei ein Spannungsregler parallel zu jedem Oberteil-Pulstransformator (23) und zu jedem Unterteil-Pulstransformator (34) montiert ist, sowie gegebenenfalls zu jedem Zweiter-Oberteil-Pulstransformator (83) und zu jedem Zweiter-Unterteil-Pulstransformator (94).

9. System (100) zum Erzeugen von Plasmastrahlen, welches aufweist einen Generator (1) für Hochspannungspulse gemäß einem der Ansprüche 1 bis 8 sowie eine Plasmaquelle (110), welche mit mindestens einer Kapillare (120) verbunden ist.

## Claims

1. High-voltage pulse generator (1) comprising:
- a pulse generator (4) configured for generation of control pulses,
- an upper part (2) comprising a number N of upper part modules (20),
each upper part module (20) comprising an upper part transistor (21) with an isolated gate having a gate, a drain and a source, and also a control device (22) of the upper part transistor,
the control device (22) of the upper part transistor comprising an upper part pulse transformer (23) connected between the gate and the source of the upper part transistor (21), and by means of which the control pulses of the pulse generator are coupled to the upper part transistor (21),
the upper part modules (20) being connected in series from a first module to a last module such that the source of an upper part transistor (21) of an upper part module (20) is connected to the drain of an upper part transistor (21) of an adjacent upper part module (20),
the high-voltage pulse generator comprising furthermore
- a lower part (3) comprising a number M of lower part modules (30),
each lower part module (30) comprising a lower part transistor (31) with an isolated gate having a gate, a drain and a source, and also a control device (32) of the lower part transistor,
the control device (32) of the lower part transistor comprising inverse control means (33) of the lower part transistor and also a lower part pulse transformer (34) by means of which the control pulses of the pulse generator are coupled to inverse control means (33) of the lower part transistor,
the lower part modules (30) being connected in series from a first lower part module (30a) to a last lower part module (30m) such that the source of a lower part transistor (31) of a lower part module (30) is connected to the drain of a lower part transistor (31) of an adjacent lower part module (30),
- a continuous high-voltage source (5) connected between the upper part transistor (21) of the first upper part module (20a) and the lower part transistor (31) of the last lower part module (30m),
- an output terminal (6) mounted between the upper part (2) and the lower part (3), connected to the upper part transistor (21) of the last upper part module (20n) and to the lower part transistor (31) of the first lower part module (30a),
the inverse control means (33) of the lower part transistor of each lower part module (30) comprising:
- a second transistor (35) with a source connected to the source of the lower part transistor (31) and a drain connected to the gate of said lower part transistor (31),
- a supply device (36) of the second transistor supplying the drain of said second transistor (35) from the drain of the lower part transistor (31),
and in which the lower part pulse transformer (34) is mounted in parallel with the second transistor (35) by being connected to the gate and to the source of the second transistor (35).

2. Generator according to claim 1, in which said supply device (36) of the second transistor comprises a resistive element (37) for supplying the second transistor mounted between the drain of the second transistor (35) and the drain of the lower part transistor (31) and also voltage regulation means (23a) between the drain and the source of the second transistor (35).

3. Generator according to one of the claims 1 and 2, in which the number N of upper part modules (20) is equal to the number M of lower part modules (30).

4. Generator according to one of the claims 1 to 3, comprising furthermore:
- a second control pulse generator (10),
- a second upper part (8) comprising a number N' of second upper part modules (80),
each second upper part module (80) comprising a second upper part transistor (81) with an isolated gate having a gate, a drain and a source, and also a control device (82) of the second upper part transistor,
the control device (82) of the second upper part transistor comprising a second upper part pulse transformer (83) connected between the gate and to the source of the second upper part transistor (81), and by means of which the control pulses of the second pulse generator are coupled to the second upper part transistor (81),
the second upper part modules (80) being connected in series from a first second upper part module (80a) to a last second upper part module (80n') such that the source of a second upper part transistor (81) of a second upper part module (80) is connected to the drain of a second upper part transistor (81) of an adjacent second upper part module (80),
- a second lower part (9) comprising a number M' of second lower part modules (90),
each second lower part module (90) comprising a second lower part transistor (91) with an isolated gate having a gate, a drain and a source, and also a control device (92) of the second lower part transistor,
the control device (92) of the second lower part transistor comprising inverse control means (93) of the second lower part transistor and also a second lower part pulse transformer (94) by means of which the control pulses of the second pulse generator are coupled to the inverse control means (93) of the second lower part transistor,
the second lower part modules (90) being connected in series from a first second lower part module (91a) to a last second lower part module (91m') such that the source of a second lower part transistor (91) of a second lower part module (90) is connected to the drain of a second lower part transistor (91) of an adjacent second lower part module (90),
- a second continuous high-voltage source (11) connected between the second upper part transistor (81) of the first second upper part module (80a) and the second lower part transistor (91) of the last second lower part module (91m'),
and in which the output terminal (6) is connected:
to the upper part transistor (21) of the last upper part module (20n),
to the second upper part transistor (81) of the last second upper part module (80n'),
to the lower part transistor (31) of the first lower part module (20a), and
to the second lower part transistor (91) of the first second lower part module (91a).

5. Generator according to claim 4, in which the continuous high-voltage source (5) is a positive high-voltage source connected between the drain of the upper part transistor (21) of the first upper part module (20a) and the source of the lower part transistor (31) of the last lower part module (30m),
in which the second continuous high-voltage source (11) is a negative high-voltage source connected between the source of the second upper part transistor (81) of the first second upper part module (80a) and the drain of the second lower part transistor (91) of the last second lower part module (91m'),
in which the lower part (3) and the second lower part (9) are mounted antiparallel so that
- the drain of the lower part transistor (31) of the first lower part module (30a) is connected to the source of the second lower part transistor (91) of the first second lower part module (90a) and
- the source of the lower part transistor (31) of the last lower part module (30m) is connected to the drain of the second lower part transistor (91) of the last second lower part module (90m'), and
in which each lower part module (30) and each second lower part module (90) comprises furthermore a locking device (12) mounted in series with the transistor with an isolated gate of said module, in particular a diode.

6. Generator according to one of the claims 4 and 5, in which the number N of upper part modules (20) is equal to the number N' of second upper part modules (80).

7. Generator according to one of the claims 1 to 6, in which a resistive element and a capacitive element are mounted in parallel with each upper part transistor (21) and each lower part transistor (31), and also if necessary with each second upper part transistor (81) and each second lower part transistor (91), so as to distribute the voltage between said transistors.

8. Generator according to one of the claims 1 to 7, in which a voltage regulator is mounted in parallel with each upper part pulse transformer (23) and each lower part pulse transformer (34), and also if necessary with each second upper part pulse transformer (83) and each second lower part pulse transformer (94).

9. System (100) for producing plasma jets comprising a high-voltage pulse generator (1) according to one of the claims 1 to 8 and also a plasma source (110) connected to at least one capillary (120).
